Europäisches Patentamt

European Patent Office

Office européen des brevets

(19)

(11) Publication number: **0 310 390**
**A2**

(12) # EUROPEAN PATENT APPLICATION

(21) Application number: **88309046.6**

(22) Date of filing: **29.09.88**

(51) Int. Cl.4: **H 03 K 17/687**
**H 03 K 3/356**

(30) Priority: **30.09.87 US 102718**

(43) Date of publication of application:
**05.04.89 Bulletin 89/14**

(84) Designated Contracting States: **DE FR IT NL**

(71) Applicant: **GENERAL ELECTRIC COMPANY**
**1, River Road**
**Schenectady New York 12345 (US)**

(72) Inventor: **Hoover, Merle Vincent**
**174 Thatcher Hill Road**
**Flemington New Jersey 08822 (US)**

(74) Representative: **Smith, Thomas Ian Macdonald et al**
**London Patent Operation G.E. Technical Services Co.**
**Inc. Burdett House 15-16 Buckingham Street**
**London WC2N 6DU (GB)**

(54) **A latching switch.**

(57) The switch includes three pairs of CMOS-FET transistors (11,12; 21,22; 31,32) having their channels serially connected between two switch terminals (14,18). The second pair (21,22) of CMOS-FETs controls the first pair (11,12) in either a latched-on or latched-off state. The control of the said second pair of CMOS-FETs, in turn, is by the third pair (31,32) of CMOS-FETS. The gate electrode of the first transistor (32) of the third CMOS-FET pair serves as a turn-on terminal (37) for changing the conduction states in the second pair (21,22) so as to latch the first pair (11,12) into a state of current conduction between the two switch terminals (14,18). The gate electrode of the second transistor (31) of the third pair serves as a turn-off terminal (34) for changing the conduction states of the second pair (21,22) so as to latch-off conduction between the two switch terminals.

Description

## A LATCHING SWITCH

This invention relates to a solid state switch that can be latched-on. The invention alternatively relates to a semiconductive switch that can be latched on or closed by a trigger pulse applied to a turn-on terminal and can be latched off or opened by a trigger pulse applied to a turn-off terminal.

Various circuits are known that can be latched on or unlatched by voltage pulses applied to appropriate terminals. Typically such circuits are implemented by silicon controlled rectifiers (SCR) including the gate turn-off (GTO) type of SCR. A classic SCR comprises a pair of complementary bipolar transistors integrated in a common substrate to form a four layer or PNPN device.

However because of the recent proliferation of insulated gate field effect transistors or IGFETS, also described as metal-oxide-semiconductor-field effect transistors or MOSFETS, or more simply MOS transistors, thero is need for the equivalent of the classic SCR more compatible with MOSFET technology.

Accordingly, it is desirable to have an electronic switch that has the essential electric characteristics of an SCR and that can be implemented in MOS technology. To this end it should be capable of being latched closed by a single trigger pulse applied to a turn-on terminal and will retain its latched state indefinitely as long as there is maintained between its two switch terminals, usually termed the cathode and anode, an adequate sustain voltage. Additionally, it should be capable of being turned off, even though the voltage maintained across the switch terminals is at or exceeds the sustain voltage, by applying an appropriate trigger pulse to its turn-off terminal.

A switch of one aspect of the invention includes first and second switch terminals for passing a current therebetween when the switch is enabled (i.e. on) and passing essentially no current therebetween when the switch is disabled (i.e. off). The switch comprises a field effect transistor (FET) having first and second output electrodes and a gate electrode, state maintenance means having an input terminal and an output terminal, current passage means having first and second terminals, and switching means. The first output electrode of the FET is coupled to one of the first and second switch terminals. The second terminal of the current passing means is coupled to the other of the two switch terminals. The second output electrode of the FET is coupled to the first terminal of the current passing means and to the input terminal of the state maintenance means. The gate electrode of the FET is coupled to the switching means and to the output terminal of the state maintenance means.

In an embodiment, the switching means is adapted to selectively bias on the FET for a sufficient period of time so as to allow current to flow through the switch from one of the switch terminals, through the FET and current passing means, and into the other switch terminal, and to selectively bias off the FET for a sufficient period of time to cut off current flow through the FET and to thus cut off current flow through the switch. The state maintenance means is adapted to maintain the FET biased on after the switching means has biased the FET on and then discontinues such turn-on bias, and to maintain the FET biased off even after the switching means has biased the FET off and then discontinues such turn-off bias. Thus the state maintenance means provides positive feed back which maintains the state of the switch even after turn-on and turn-off bias of the switching means is discontinued.

In a preferred embodiment the current passage means is a second field effect transistor which is of the opposite conductivity type of the first FET, the state maintenance means is an inverter circuit comprising a second pair of complementary field effect transistors, and the switching means comprises a third pair of complementary field effect transistors and two coupling means which are typically resistors. One of the resistors is coupled between the gate terminal of one of the FETS of the third pair of FETS and one of the switch terminals. The other resistor is coupled between the gate terminal of the other FET of the third pair and the other switch terminal. All of the field effect transistors are typically Insulated Gate Field Effect Transistors (IGFETS).

The invention may be better understood with aid of the detailed description taken in conjunction with the accompanying drawing.

### Brief Description of the Drawing

The sole figure is a schematic diagram of an illustrative circuit embodying the invention.

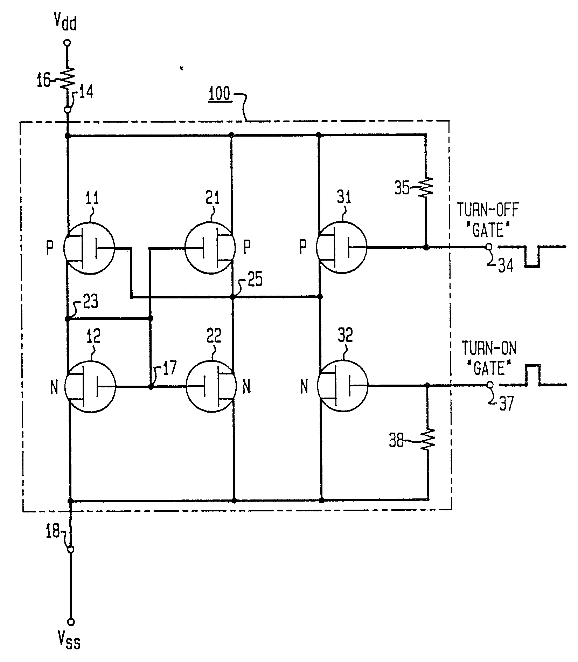

Referring now to FIG. 1, there is shown within the dashed line rectangle a latching circuit 100 in accordance with the present invention. The manufacture of latching circuit 100 in integrated circuit form is compatible with C-MOS processing technology. Latching circuit 100 will also be referred to as circuit 100 or switch 100. Switch 100 has two switch (output) terminals 14 and 18 and in one illustrative embodiment comprises P-type field effect transistors (FETs) 11, 21 and 31, N-type field effect transistors (FETS) 12, 22 and 32 and resistors 35 and 38. In the illustrative embodiment all the transistors are enhancement mode metal-oxide-semiconductor transistors with the semiconductor typically being silicon. The switch 100 is configured to function like a Gate Turn-Off Silicon Controlled Rectifier (GTO-SCR). In an "on" (conducting) state a low impedance path between switch terminals 14 and 18 exists through biased on transistors 11 and 12. In an "off" (non-conducting) state a high impedance path (essentially an open circuit) exists between switch terminals 14 and 18 with all transistors, except transistor 21, being biased off. Once the switch 100 is in the "on" or in the "off" state the combination of transistors 21 and 22 acts to maintain the switch 100 in that state unless a turn-on or turn-off pulse is applied to the turn-on and turn-off terminals, respectively. The operation of the switch 100 is described in detail below.

The transistors may be referred to as FETS or switching devices and the N or P near each denotes its conductivity type. Resistors 35 and 38 are also denoted as first and second coupling means. Transistors 21 and 22 are also denoted as state maintenance means or as an inverter circuit, and transistors 31 and 32 are also denoted as switching means. Transistor 12 may be denoted as current passage means.

Switch 100 is shown coupled by switch terminal 14 through a resistor 16 to a bus terminal to which is applied positive or Vdd potential of a power supply (not shown) and coupled by switch terminal 18 to a ground potential terminal Vss of the power supply. Resistor 16 is also denoted as a load or load element.

Each of the transistors has source, drain and gate electrodes. For the sake of simplicity the source, drain and gate electrodes will be referred to as simply the gate, drain and source. Transistor 11 has its channel (also denoted as a drain-source circuit) serially coupled with the channel of transistor 12 to form a first pair of series-connected complementary transistors. The source of transistor 11 is connected to switch terminal 14, that in turn is connected by way of load resistor 16 to Vdd. The source of transistor 12 is connected to switch terminal 18 that is coupled to the Vss bus terminal. Also having their channels serially connected between switch terminals 14 and 18 are a second complementary pair of transistors comprising transistors 21 and 22 and a third pair of complementary transistors comprising transistors 31 and 32.

The gates of transistors 12, 21 and 22 are coupled to the drains of transistors 11 and 12 and to a node 23. Transistor 12, which has its drain and gate coupled together, effectively acts as a diode. The gate of transistor 11 is coupled to the drains of transistors 21, 22, 31 and 32 and to a node 25. The gate of transistor 31 is coupled both to a turn-off terminal 34 and bY way of the resistor 35 to switch terminal 14. The gate of transistor 32 is coupled both to a turn-on terminal 37 and by way of resistor 38 to the switch terminal 18. Switch terminals 14 and 18 act as the equivalent anode and cathode terminals, respectively, of an SCR. Terminals 34 and 37 act as the turn-on and turn-off terminals, respectively of a Gate Turn-Off type SCR (GTO-SCR).

In one typical embodiment each of the transistors involved is a conventional enhancement-mode MOS transistor of the channel type indicated and in each the substrate and the source are shorted together in the usual fashion to reduce noise susceptibility. In a silicon-on-sapphire embodiment the bulk region is typically not shorted to the source.

Transistors 12 and 22 function as the input and output elements of a current mirror and transistor 22 need conduct only relatively small control currents and so its channel width (the direction transverse to the path of the flow) may be much smaller than that of transistor 12. Similarly the channel width of transistor 21 may be much smaller than that of transistor 11. Moreover, since transistors 31 and transistors 32 need only carry enough current to overpower transistors 21 and 22, respectively, each of transistors 31 and 32 may also have channel widths small compared to those of transistors 11 and 12, respectively. A consequence of this is that comparatively small transistors may be used for transistors 21, 22, 31 and 32 to control relatively large transistors 11 and 12.

The operation of switch 100 will first be described assuming that there is essentially no conduction through switch 100 with Vdd coupled to switch terminal 14 through resistor 16, with Vss coupled to switch terminal 18, and with no voltages applied to turn-off terminal 34 or to turn-on terminal 37. In this state, denoted as the quiescent state, transistor 31 is biased off since the potential of its gate is essentially the same as its source because of the presence of resistor 35 and transistor 32 is also biased off since the potential of its gate is essentially the same as its source because of the presence of resistor 38.

Because the total gate-source interelectrode capacitance (not shown) of transistors 12 and 22 is larger than that of transistor 21 because of the larger total area involved, the potential at node 23 will be held essentially equal to that of node 18 and therefore transistors 11 and 21 will remain nonconductive because the source-to-gate voltage Vgs potential will normally be less than their threshold voltage Vth for conduction. On the other hand, transistor 21 is biased on because its gate, which is directly connected to node 23, is negatively biased with respect to its source which is tied to node 14 which is at the potential of the positive bus Vdd. Accordingly, transistor 21 conducts until node 25 is pulled up to a high potential approaching that of node 14. Transistor 21 then ceases to conduct. This biases off transistor 11 because its gate-source potential will be less than its threshold voltage. The switch 100 is thereby kept in an openstate (no current flow between switch terminals 14 and 18) despite the application of a positive potential on switch terminal 14 relative to switch terminal 18.

To cause switch 100 to switch to an "on" state (a conducting state in which the impedance across switch 100 is low), a positive-going momentary pulse (as is shown in the FIGURE) of sufficient amplitude is applied to the turn-on terminal 37 while terminal 34 has no voltage directly applied thereto. Transistor 32 is turned-on at least momentarily while transistor 31 remains biased off. This pulls down the potential of node 25 to essentially the level of Vss (typically ground potential) by drawing drain-current out of transistor 21 so as to overcome its quiescent pulled-up state. At this time transistors 21 and 32 are biased on and conducting. The relative geometries of transistors 21 and 32 are selected such that the potential of node 25 is close to Vss. When node 25 is momentarily pulleddown in potential by transistor 32 to a level close to that of Vss, the potential of the gate of transistor 11 is pulled down until transistor 11 is biased on and conducts. The current flowing through transistor 11, and the relative geometry of transistor 11 compared to the geometry of transistor 12, increases the potential of node 23 sufficiently to bias on transistors 12 and 22 which begin to conduct. This provides a complete electrical path for current to flow from Vdd, through resistor 16, through transistors 11 and 12, and then into switch terminal 18 and Vss. The increase in potential of node 23 also biases off transistor 21. At this time transistor 22 also functions as an auxiliary pull-down on node 25, thereby latching transistors 11 and 12 into conduction during the period of time following the duration of the trigger pulse on terminal 37. Thus, although transistor 32 becomes pulsed off, the duration of the turn-on time of transistor 32 need only be long enough to enable transistor 22 to be biased on such that node 25 is pulled down to a potential level close to Vss. Accordingly, once switch 100. is turned on it is latched on and continues to act as a closed switch between Vdd and Vss so long as the voltage difference between switch terminals 14 and 18 is above a sustain voltage level. If the level of the voltage applied across switch terminals 14 and 18 drops below that needed fcr maintaining the switch 100 closed (conducting current), the switch 100 will open (cease to conduct current) in the manner analogous to that of an SCR. Switch 100 acts as a regeneratively latched circuit that effectively has negative resistance characteristics.

The switch 100 described has the further advantage that it can also implement a controlled turn-off function in the manner of a gate turn-off type of SCR, a GTO-SCR. In many instances, it is desirable to turn the switch 100 off without dropping the voltage maintained across the switch 100 below its sustaining voltage. The described switch 100 is readily adaptable for turn-off directly by the application simply of a trigger pulse to the turn-off terminal 34.

Assuming now that switch 100 is conducting, it can be turned off by the application of a momentary negative-going pulse (as is shown in the FIGURE) of sufficient amplitude applied to turn-off terminal 34. This negative going pulse biases on transistor 31 which begins to conduct and pulls the potential of node 25 towards the potential level of Vdd. At this time transistor 22 is also on and tries to clamp the voltage of node 25 at Vss. Transistor 31 is designed to be larger than transistor 22 such that transistor 31 controls the potential of node 25 when transistors 31 and 22 are both biased on. As the potential of node 25 is being pulled up, the gate-to-source voltage of transistor 11 decreases and it becomes biased off and the current flow therethrough ceases. This results in a corresponding current flow decease and then cut off through transistor 12. Ultimately, this degenerative sequence pulls the potential of node 25 positive enough to completely cut-off conduction through transistor 11 and then through transistor 12. As this happens the potential of node 23 decreases towards that of node 18. This biases off transistor 22 and biases on transistor 21 which begins to conduct. Biased on and conducting transistor 21 causes node 25 to stay close in potential to Vdd and thus insures that transistor 11 remains biased off and non-conduction even after the pulse applied to turn-off terminal 34 terminates. Thus transistor 31 need only be biased on and conducting for long enough to allow transistor 11 to be biased off and transistor 21 to be biased on. This locks the switch 100 in the "off" state since node 25 stays at a potential close to that of Vdd which keeps transistor 11 biased off. With transistor 11 biased off, node 23 is close in potential to Vss and this biases off transistors 12 and 22. The voltage pulses applied to terminals 34 and 37 do not overlap and thus while transistor 31 is on and charging node 25 towards the potential of Vdd, transistor 32 is biased off. Accordingly, no electrical path exists between switch terminal 14 and 18 at this time since transistors 12, 22 and 32 are all biased off.

It is evident that an advantage of the present switch 100 is that it can be connected in series with the load resistor as described, and hence need not be independently powered, with the current and power needed to maintain the switch in a conductive state being supplied by the voltage supply powering the load.

It can be appreciated that various modifications may be made in the basic circuit described without departing from the spirit of the invention. For example, the conductivity types of the transistors can be reversed provided the polarity of the power supply is reversed. Still further, transistors 21 and 22 and transistors 31 and 32 can be replaced by other configurations that perform essentially the same functions. Furthermore, all the transistors can be fabricated in an epitaxial layer deposited on a sapphire substrate as is the case with silicon-on-sapphire (SOS) devices. Still further, resistor 16 could be coupled between switch terminal 18 and Vss with terminal 14 connected directly to Vdd. Still further, transistor 12 could be replaced by a resistor or other type of impedance or current conducting element.

## Claims

1. A switch comprising:
   first and second switch terminals;
   a first field effect transistor (FET) having first and second output electrodes and a gate electrode;
   current passage means, which includes first and second terminals, for allowing current to flow between the terminals thereof;
   switching means, which is coupled to the gate electrode of the FET, for biasing on the FET with a biasing-on signal or for biasing off the FET with a biasing-off signal;
   state maintenance means, which includes an input terminal coupled to the second output electrode of the FET and to the first terminal of the current passage means and includes an output terminal coupled to the gate electrode of the FET, for, in the absence of a turn-off bias signal of the switching means, maintaining the first transistor biased on if the first transistor is biased on and for, in the absence of a turn-on bias signal of the switching means, maintaining the first transistor biased off if the first transistor is biased off.

2. A switch comprising:

first and second switch terminals;

first, second and third pairs of complementary field effect transistors connected in parallel between said first and second switch terminals, the two transistors of each pair having their channels coupled in series between the first and second switch terminals with a common node therebetween, and each transistor having a source, drain and gate electrodes;

the common node between the two transistors of the first pair being coupled to the gate electrode of the second transistor of the first pair and to the gate electrodes of each of the two transistors of the second pair;

the common node between the two transistors of the second pair being coupled to the common node between the two transistors of the third pair and to the gate electrode of the first transistor of the first pair;

the gate electrode of the first transistor of the third pair being coupled to a turn-off terminal and being resistively coupled to the first switch terminal; and

the gate electrode of the second transistor of the third pair being coupled to a turn-on terminal and being resistively coupled to the second switch terminal.

3. The switch of claim 2 in which the first transistor of each pair is P-type and the second transistor of each pair is N-type.

4. The switch of Claim 2 or 3 in which all of the transistors are metal-oxide-semiconductor field effect transistors.

5. The switch of Claim 2 or 3 in which all of the transistors are insulated gate field effect transistors.

6. The switch of Claim 2, 3, 4 or 5 in which the first switch terminal is connected by way of a load to a positive bus of a power supply and the second switch terminal is coupled to a negative bus of the power supply.

7. A switch adapted to be coupled by way of first and second switch terminals in series with a load resistor and to be latched in either an "on" or "off" state by means of trigger pulses applied to a turn-on and turn-off terminals, respectively, comprising:

first and second complementary field effect transistors connected with their channels in series between the first ad second switch terminals;

third and fourth complementary field effect transistors connected with their channels in series between the first and second switch terminals;

fifth and sixth complementary field effect transistors connected with their channels in series between the first and second switch terminals;

a common node between the first and second transistors being coupled to gates electrodes of the first, third and fourth transistors;

a gate electrode of the second transistor being coupled to nodes between the third and fourth transistors and between the fifth and sixth transistors; and

gate electrodes of the fifth and sixth transistors being coupled to the turn-on and turn-off terminals, respectively, and being resistively coupled to the first and second switch terminals, respectively

8. The switch of claim 7 in which the first, third and fourth transistors are P-type enhancement mode field effects transistors and the second, fourth and sixth transistors are N-type enhancement mode field effect transistors.

9. The switch of Claim 7 or 8 wherein all the transistors are enhancement mode metal-oxide-semiconductor type field effect transistors.

10. The switch of Claim 7 or 8 wherein all of the transistors are enhancement mode insulated gate field effect transistors.

11. The switch of Claim 7, 8, 9 or 10 wherein the channel widths of the first and second transistors are wider than those of the third, fourth, fifth and sixth transistors.

12 In combination:

first and second power terminals for the application therebetween of an operating potential;

a load element being coupled between one of said first and second power terminals and an intermediate node;

a switch, which is coupled between said intermediate node and the other one of said first and second power terminals, for selectively enabling current flow through the load element comprising:

first and second complementary field effect transistors (FETs) each having source, drain and gate electrodes;

an inverter circuit having an input terminal, an output terminal and first and second terminals for the application therebetween of an operating potential;

the source electrode of the first FET being coupled to the intermediate node;

the source electrode of the second FET being coupled to said other of said first and second power terminals;

the drain electrode of the first FET being coupled to the drain and gate electrodes of the second FET and to the input terminal of the inverter circuit;

the gate electrode of the first FET being coupled to the output terminal of the inverter circuit;

first and second switching devices each having a conduction path and a control terminal;

means connecting the conduction path of said first switching device between said intermediate node and the output terminal of the inverter circuit;

means connecting the conduction path of said second switching device between the output terminal of the inverting circuit and said other one of said first and second power terminals;

the control electrode of the first switching device being coupled to a turn-off terminal of the switch and being coupled through first coupling means to the intermediate node; and the control terminal of the second switching device being coupled to a turn-on terminal of the switch and being coupled through second coupling means to said other of the first and second power terminals.

13. The combination of Claim 12 wherein the first and second switching devices are third and fourth field effect transistors respectively.

14. The combination of claim 13 wherein the first and second switching devices are insulated gate field effect transistors with the first switching device having the same conductivity type as the first FET and the second switching switching device having the same conductivity as the second FET.

15. The combination of Claim 13 or 14 wherein: the inverter circuit comprises fifth and sixth field effect transistors with the fifth FET having the same conductivity type as the first FET and with the sixth FET having the same conductivity type as the second FET; gate electrodes of the fifth and sixth FETS being coupled to the input terminal of the inverter circuit; drain electrodes of the fifth and sixth sixth FETS being coupled to the output terminal of the inverter circuit; and a source electrode of the fifth FET being coupled to said intermediate node and a source electrode of the sixth electrode being coupled to said other of said first and second power terminals.

16. The combination of Claim 15 wherein the first, third and fifth FETS are P-type enhancement mode metal-oxide-semiconductor transistors and the second, fourth and sixth FETS are N-type enhancement mode metal-oxide-semiconductor transistors.

17. The combination of Claim 12, 13, 14, 15 or 16 wherein the first and second coupling means are resistive means.

18. A switch comprising:
first and second switch terminals;
first and second complementary field effect transistors each having first and second output electrodes and a gate electrode;
the first output electrode of the first transistor being coupled to the first switch terminal, and the first output electrode of the second transistor being coupled to the second switch terminal;
the second output electrodes being coupled together and being coupled to the gate electrode of the second transistor;
switching means having turn-on and turn-off terminals and having an output terminal coupled to the gate electrode of the first transistor for selectively biasing same on in response to a turn-on signal applied to the turn-on terminal and for biasing off the first transistor in response to a turn-off signal applied to the turn-off terminal; and
state maintenance means, which has an input terminal coupled to the gate electrode of the second transistor and has an output terminal coupled to the gate electrode of the first transistor and to the output terminal of the switching means, for, in the absence of a turn-on signal applied to the turn-on terminal, selectively maintaining the first transistor biased on if the first transistor is biased on and for, in the absence of a turn-off signal applied to the turn-off terminal, selectively maintaining the first transistor biased off if the first transistor is biased off.

19. In combination:
first and second power terminals for the application therebetween of an operating potential;
a load element being coupled between one of said first and second power terminals and an intermediate node;
a switch, which is coupled between said intermediate node and the other one of said first and second power terminals, for selectively enabling current flow through the load element comprising:
first and second complementary field effect transistors (FETs) each having source, drain and gate electrodes;
an inverter circuit having an input terminal, an output terminal and first and second terminals for the application therebetween of an operating potential;
the source electrode of the first FET being coupled to the intermediate node;
the source electrode of the second FET being coupled to said other of said first and second power terminals;
the drain electrode of the first FET being coupled to the drain and gate electrodes of the second FET and to the input terminal of the inverter circuit;
the gate electrode of the first FET being coupled to the output terminal of the inverter circuit;
first and second switching devices each having first and second output terminals and a control terminal;
the second output terminals of the first and second switching devices being coupled to the output terminal of the inverter circuit;
the first output terminal of the first switching device being coupled to the intermediate node;
the first output terminal of the second switching device being coupled to said other one of said first and second power terminals;
the control electrode of the first switching device being coupled to a turn-off terminal of the switch and being coupled through first coupling means to the intermediate node; and
the control terminal of the second switching device being coupled to a turn-on terminal of the switch and being coupled through second coupling means to said other of the first and second power terminals.

20. A switch comprising:

a switching device (11) having a main conduction path and a control electrode;

current passage means (12), in series with the main conduction path of the switching device (11);

switching means (32), which is coupled to the control electrode of the switching device, for biasing on the device with a biasing-on signal; and

state maintenance means (21,22), which includes an input coupled to the junction (23) of the device (11) with the current passage means (12) and includes an output (25) coupled to the control electrode of the device, for maintaining the device (11) biased on if the device is biased on and for, in the absence of a turn-on bias signal of the switching means, maintaining the device off if the device is biased off.